(19)

**Europäisches Patentamt**

**European Patent Office**

**Office européen des brevets**

(11) **EP 4 513 755 A1**

(12) **EUROPEAN PATENT APPLICATION**

(43) Date of publication:
26.02.2025  Bulletin 2025/09

(21) Application number: 24194244.0

(22) Date of filing: 13.08.2024

(51) International Patent Classification (IPC):
$H03F\ 3/183^{(2006.01)}$   $H03F\ 3/217^{(2006.01)}$
$H03G\ 3/30^{(2006.01)}$   $H02M\ 1/00^{(2006.01)}$

(52) Cooperative Patent Classification (CPC):
H03F 3/2175; H02M 1/00; H03F 3/183;
H03F 3/2171; H03G 3/3005

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority:  17.08.2023  US 202363520260 P
09.08.2024  US 202418798988

(71) Applicant: Maxim Integrated Products, Inc.
San Jose, CA 95134 (US)

(72) Inventors:
• HEMATY, Arman
  Camas (US)
• ASHBURN JR., Michael A.
  Groton (US)
• SHTARGOT, Leonard
  Campbell (US)
• HAMMERSCHMIED, Clemens Maria
  Sunnyvale (US)

(74) Representative: Horler, Philip John
Withers & Rogers LLP
2 London Bridge
London SE1 9RA (GB)

(54) **SYSTEMS AND METHODS FOR PROVIDING AN ANALOG OUTPUT SIGNAL USING A CLASS-D AMPLIFIER**

(57)    A method for providing an analog output signal includes (a) amplifying a digital first internal signal using a first Class-D amplifier to generate a digital first output signal, (b) filtering the digital first output signal to generate an analog first output signal, (c) providing the analog first output signal to a first load, (d) sensing the analog first output signal to generate an analog first feedback signal, (e) converting the analog first feedback signal to a digital first feedback signal, and (f) configuring the first Class-D amplifier for an impedance of the first load by generating the digital first internal signal at least partially based on the digital first feedback signal.

EP 4 513 755 A1

**Description**

**BACKGROUND**

Analog communication is widely used in factory automation applications and in process control applications. For example, programmable logic controllers, programmable automation controllers, and digital control systems, which are frequently used in factory automation applications and in process control applications, are commonly configured to generate analog output signals.

**SUMMARY**

In an embodiment, a method for providing an analog output signal includes (i) amplifying a digital first internal signal using a first Class-D amplifier to generate a digital first output signal, (ii) filtering the digital first output signal to generate an analog first output signal, (iii) providing the analog first output signal to a first load, (iv) sensing the analog first output signal to generate an analog first feedback signal, (v) converting the analog first feedback signal to a digital first feedback signal, and (vi) configuring the first Class-D amplifier for an impedance of the first load by generating the digital first internal signal at least partially based on the digital first feedback signal.

In an embodiment, a programmable controller includes (i) a processing system configured to generate a digital first internal signal at least partially according to (a) programming instructions provided to the processing system and (b) a digital first feedback signal, (ii) a first Class-D amplifier configured to amplify the digital first internal signal to generate a digital first output signal, (iii) a first filter configured to filter the digital first output signal to generate an analog first output signal, (iv) first sensing circuitry configured to sense the analog first output signal to generate an analog first feedback signal, and (v) a first analog-to-digital converter (ADC) configured to convert the analog first feedback signal to the digital first feedback signal.

In an embodiment, an electrical environment includes a programmable controller and a first load. The programmable controller includes (i) a processing system configured to generate a digital first internal signal at least partially according to (a) programming instructions provided to the processing system and (b) a digital first feedback signal, (ii) a first Class-D amplifier configured to amplify the digital first internal signal to generate a digital first output signal, (iii) a first filter configured to filter the digital first output signal to generate an analog first output signal, (iv) first sensing circuitry configured to sense the analog first output signal to generate an analog first feedback signal, and (v) a first analog-to-digital converter (ADC) configured to convert the analog first feedback signal to the digital first feedback signal. The first load is powered by the analog first output signal.

BRIEF DESCRIPTION OF THE DRAWINGS

FIG. 1 is a block diagram of an electrical environment including a programmable controller and a load.
FIG. 2 is a block diagram of an electrical environment including a system for providing an analog output signal using a Class-D amplifier, according to an embodiment.
FIG. 3 is a graph illustrating voltage of a digital output signal in one example of operation of an embodiment of the FIG. 2 electrical environment.
FIG. 4 is a graph illustrating current of a digital output signal in one example of operation of an embodiment of the FIG. 2 electrical environment.
FIG. 5 is a schematic diagram of one embodiment of the Class-D amplifier of the FIG. 2 electrical environment.
FIG. 6 is a schematic diagram of one embodiment of a filter of the FIG. 2 electrical environment.
FIG. 7 is a schematic diagram of one embodiment of sensing circuitry of the FIG. 2 electrical environment.
FIG. 8 is a block diagram of an electrical environment including a programmable controller including a Class-D amplifier, according to an embodiment.
FIG. 9 is a flow chart of a method for generating an analog output signal using a Class-D amplifier, according to an embodiment.
FIG. 10 is a block diagram of an electrical environment including an alternate embodiment of the FIG. 8 programmable controller configured to support a plurality of channels.
FIG. 11 illustrates one embodiment of output modules of the FIG. 10 programmable controller.
FIG. 12 is a block diagram of an alternate embodiment of the FIG. 10 electrical environment.

**DETAILED DESCRIPTION OF THE EMBODIMENTS**

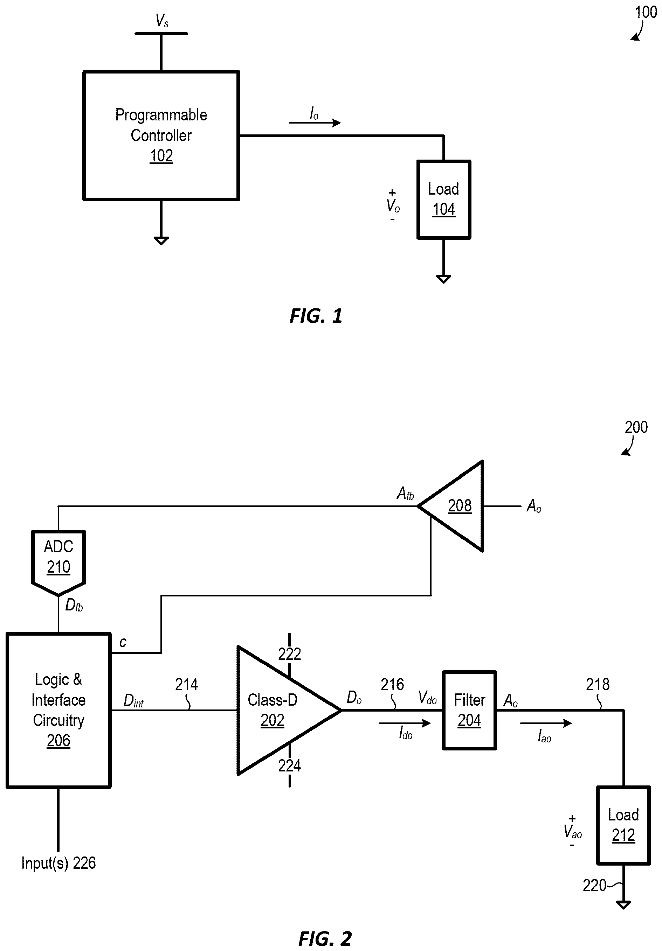

An analog signal generated by a programmable controller, such as a programmable logic controller (PLC), a programmable automation controller (PAC), or a programmable controller of a digital control system (DCS), may need to drive a load having a wide range of possible impedance values. For example, FIG. 1 is a block diagram of an electrical environment 100 including a programmable controller 102 and a load 104. Programmable controller 102 is powered from a power supply having a fixed voltage $V_s$, and programmable controller 102 is configured to generate an analog output current signal $I_o$ having a magnitude of up to 20 milliamperes (mA) by controlling an amplifier within programmable controller 102 including one or more transistors (not shown) operating in their respective saturation regions. In this example, load 104 has an impedance that may range between zero and 1,000 ohms. Consequently, a voltage $V_o$ across load 104 may significantly vary according to impedance of load 104. For example, if analog output current signal $I_o$ has a magnitude of 20 mA and load 104 has an impedance of 1,000 ohms, magnitude of voltage $V_o$ is 20 volts. On the other extreme, if analog output current signal $I_o$ has a magnitude of 20 mA and load 104 has an impedance of zero, magnitude of voltage $V_o$ is zero.

Low values of voltage $V_o$ may result in significant power dissipation in programmable controller 102. For example, assume that analog output current signal $I_o$ has a magnitude of 20 mA, magnitude of voltage $V_s$ is 20 volts, and load 104 has an impedance of zero, such that magnitude of voltage $V_o$ is zero. Power dissipation ($P$) in programmable controller 102 under this scenario is equal to $P = (I_o)(V_s)$, and power dissipation in programmable controller 102 is therefore $P = (20\,mA)(20\,volts) = 0.400\,watts\,(W) = 400\,milliwatts\,(mW)$. While 400 mW power dissipation in programmable controller 102 may be acceptable in some applications, such relatively large power dissipation may limit the quantity of output channels that can be supported by a single programmable controller due to inability to adequately cool the programmable controller if multiple channels are driving low-impedance loads. For example, assume that programmable controller 102 is modified to support eight output channels, i.e., programmable controller 102 is configured to generate eight different analog output current signals for powering eight different loads. Power dissipation in programmable controller 102 could be as high as 3.2 watts under this scenario, and it may therefore be challenging to adequately cool programmable controller 102, especially in applications where programmable controller 102 is within a cabinet that restricts transfer of heat away from programmable controller 102. Cooling challenges may be particularly acute in applications of programmable controller 102 where forced air cooling is undesirable, such as in dusty applications or in noise-sensitive applications.

Disclosed herein are systems and methods for providing an analog output signal using a Class-D amplifier which may help mitigate the problem discussed above. Particular embodiments of the new systems and methods configure a Class-D amplifier for an impedance of a load by controlling operation of the Class-D amplifier, at least partially based on a voltage across the load and/or a current flowing through the load, thereby helping minimize power dissipation when the load has a low impedance. Additionally, some embodiments do not require use of a dedicated power supply for the Class-D amplifier, which promotes low system cost, small system, and system simplicity. Furthermore, certain embodiments share one or more analog-to-digital converters (ADCs) among multiple output channels, thereby promoting low system cost, small system size, and system simplicity. Accordingly, the new systems and methods may enable a programmable controller to support a greater quantity of output channels than would be feasible using conventional technology.

FIG. 2 is a block diagram of an electrical environment 200, which includes one embodiment of the new systems for providing an analog output signal using a Class-D amplifier. Electrical environment 200 includes a Class-D amplifier 202, a filter 204, logical and interface circuitry 206, sensing circuitry 208, an ADC 210, and a load 212. Class-D amplifier 202 is electrically coupled between an internal node 214 and a digital output node 216, and filter 204 is electrically coupled between digital output node 216 and an analog output node 218. Load 212 is electrically coupled between analog output node 218 and a reference node 220, where reference node 220 is depicted as being a ground node, such as an earth ground node or a chassis ground node. It is understood, though, that reference node 220 need not be a ground node, and reference node 220 accordingly could be at a different electrical potential than an earth ground or a chassis ground. Class-D amplifier 202 is at least partially powered by a first power supply rail 222 and a second power supply rail 224. In certain embodiments, first power supply rail 222 is at a positive voltage with respect to reference node 220 and second power supply rail 224 is at negative voltage with respect to reference node 220, such that first power supply rail 222 and second power supply rail 224 collectively form a split power supply. In some other embodiments, second power supply rail 224 is the same as reference node 220, and first power supply rail 222 is at a positive voltage or a negative voltage with respect to reference node 220, such that first power supply rail 222 and second power supply rail 224 collectively form a unipolar power supply.

Logic and interface circuitry 206, henceforth referred to as circuitry 206 for brevity, is configured to generate a digital internal signal $D_{int}$ on internal node 214. Circuitry 206 is optionally configured to generate digital internal signal $D_{int}$ at least partially based on one or more input signals 226 to circuitry 206. Class-D amplifier 202 is configured to amplify digital internal signal $D_{int}$ to generate a digital output signal $D_o$ on digital output node 216. Digital output signal $D_o$ is represented by one or more of (a) a current $I_{do}$ flowing out of Class-D amplifier 202 to filter 204 via digital output node 216 and (b) a voltage $V_{do}$ on digital output node 216 with respect to reference node 220. Voltage $V_{do}$, which is a digital voltage, has an average value, which may alternately be referred to as a direct current (DC) component of voltage $V_{do}$, which may be a positive value, a negative value, or zero, with respect to reference node 220.

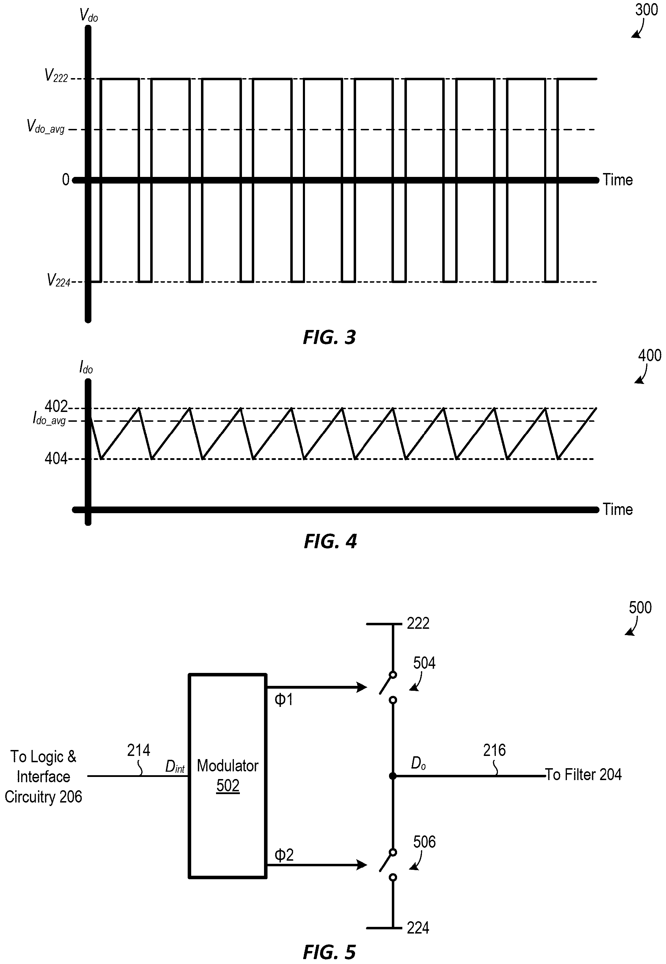

For example, FIG. 3 is graph 300 of voltage $V_{do}$ versus time illustrating one example operation of electrical environment 200 in an embodiment where first power supply rail 222 and second power supply rail 224 collectively form a split power supply having respective voltages $V_{222}$ and $V_{224}$ with respect to reference node 220. Class-D amplifier 202 drives digital output node 216 between first power supply rail 222 and second power supply rail 224 in response to digital internal signal $D_{int}$, in the FIG. 3 example. Voltage $V_{do}$ is at voltage $V_{222}$ for 75 percent of each switching cycle of Class-D amplifier 202, and voltage $V_{do}$ is at voltage $V_{224}$ for 25 percent of each switching cycle of Class-D amplifier 202, in the FIG. 3 example. Therefore, an average value ($V_{do\_avg}$) of voltage $V_{do}$ is given by EQN. 1 below, for the FIG. 3 example.

$$V_{do\_avg} = (0.75) \cdot (V_{222} - V_{224}) + V_{224} \quad \text{(EQN. 1)}$$

Additionally, Class-D amplifier 202 repeatedly drives current $I_{do}$ a maximum value and a minimum value, with a finite slope between these two values. Current $I_{do}$ also has an average value, alternately referred to as a DC component of current $I_{do}$, which may be a positive value, a negative value, or zero. For example, FIG. 4 is graph 400 of current $I_{do}$ versus time illustrating one example of operation of electrical environment 200 where current $I_{do}$ is continuous. Current $I_{do}$ ramps between a maximum value 402 and a minimum value 404, and current $I_{do}$ has an average value of $I_{do\_avg}$.

FIG. 5 is a schematic diagram of a Class-D amplifier 500, which is one possible embodiment of Class-D amplifier 202 of FIG. 2, although it is understood that Class-D amplifier 202 could be embodied in other manners without departing from the scope hereof. Class-D amplifier 500 includes a modulator 502, a first switching device 504, and a second switching device 506. First switching device 504 is electrically coupled between first power supply rail 222 and digital output node 216, and second switching device 506 is electrically coupled between digital output node 216 and second power supply rail 224. Each of first switching device 504 and second switching device 506 includes, for example, one or more transistors and driver circuitry to drive the one or more transistors. First switching device 504 is controlled by a first control signal $\Phi1$ generated by modulator 502, and second switching device 506 is controlled by a second control signal $\Phi2$ generated by modulator 502. Modulator 502 generates first control signal $\Phi1$ and second control signal $\Phi2$ in response to digital internal signal $D_{int}$, such that digital output signal $D_o$ is an amplified version of digital internal signal $D_{int}$. Certain embodiments of modulator 502 generate first control signal $\Phi1$ and second control signal $\Phi2$ using a pulse width modulation (PWM) technique or a pulse frequency modulation (PFM) technique. In some embodiments, modulator 502 is a sigma delta modulator. It should be noted that first switching device 504 and second switching device 506 repeatedly switch between their respective on-states (conductive states) and their respective off-states (non-conductive states) in response to control signals $\Phi1$ and $\Phi2$, respectively, such that first switching device 504 and second switching device 506 do not operate in their saturation regions.

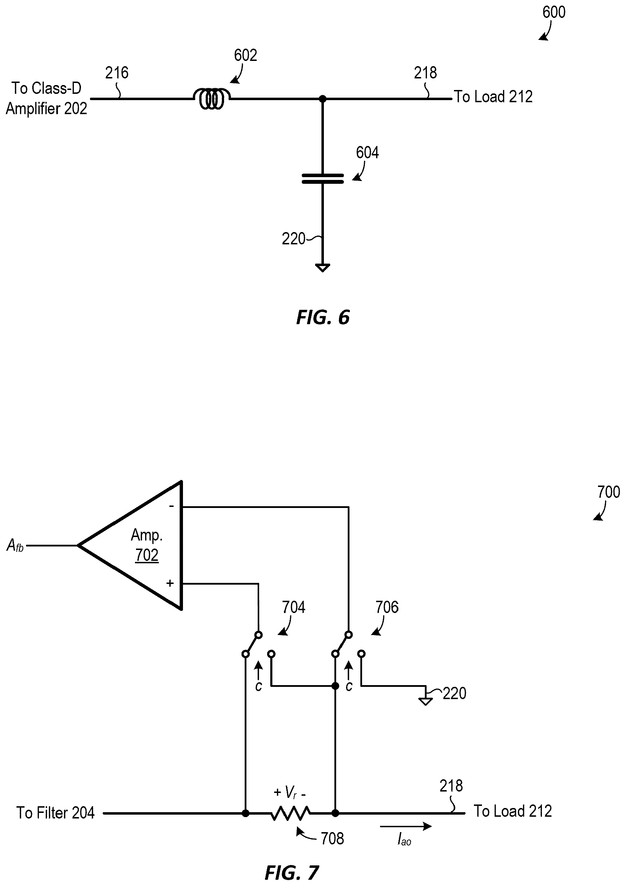

Referring again to FIG. 2, filter 204 is configured to convert digital output signal $D_o$ to an analog output signal $A_o$. Analog signal $A_o$ is ideally equal to the average value of digital output signal $D_o$, although analog signal $A_o$ will not be exactly equal to the average value of digital output signal $D_o$ because a practical implementation of filter 204 is unable to completely remove Class-D amplifier 202 switching frequency components from analog output signal $A_o$. Analog output signal $A_o$ is represented by one or more of (a) a current $I_{ao}$ flowing out of filter 204 to analog output node 218 and (b) a voltage $V_{ao}$ on analog output node 218 with respect to reference node 220. In some embodiments, filter 204 includes an inductive-capacitive filter. For example, FIG. 6 is a schematic diagram of a filter 600, which is one possible embodiment of filter 204, although it is understood that filter 204 may be embodied in other manners without departing from the scope hereof. Filter 600 includes an inductor 602 and a capacitor 604. Inductor 602 is electrically coupled between digital output node 216 and analog output node 218, and capacitor 604 is electrically coupled between analog output node 218 and reference node 220.

Referring again to FIG. 2, filter 204 provides analog output signal $A_o$ to load 212 via analog output node 218, and a voltage across load 212 is therefore the same as voltage $V_{ao}$ on analog output node 218. Additionally, current $I_{ao}$ flows through load 212. In certain embodiments, impedance of load 212 may vary within a wide range of values independently of state of analog output signal $A_o$, e.g., impedance of load 212 may vary independently of magnitude and/or phase of analog output signal $A_o$. For example, in some embodiments, impedance of load 212 may range from zero and 750 ohms. As another example, in some other embodiments, impedance of load 212 may range from zero and 1,000 ohms. It is understood, though, that load 212 is not limited to any particular impedance range. For example, in some embodiments, impedance of load 212 may be greater than 1,000 ohms. As another example, in certain embodiments, a minimum impedance of load 212 is greater than zero. Additionally, in some embodiments, impedance of load 212 may not be known before Class-D amplifier 202 is deployed in electrical environment 200. In certain embodiments, load 212 includes an industrial device, such as an actuator, a valve, a motor, a motor starter, a solenoid, an alarm, a light, a relay, a counter, a pump, a fan, a printer, a heater, a compressor, a sequencer, etc.

Sensing circuitry 208 is configured to sense analog output signal $A_o$ to generate an analog feedback signal $A_{fb}$. Analog feedback signal $A_{fb}$ represents, for example, one or more of voltage $V_{ao}$ and current $I_{ao}$. Connections between sensing circuitry 208 and analog output node 218 are not shown in FIG. 2. In some embodiments, sensing circuitry 208 includes one or more elements (not shown), such as a current sense resistor, for sensing magnitude of current $I_{ao}$, as well as one or more switches for enabling sensing circuitry 208 to selectively sense one of voltage $V_{ao}$ and current $I_{ao}$ in response to a control signal $\overline{c}$ generated by circuitry 206.

For example, FIG. 7 is a schematic diagram of sensing circuitry 700, which is one possible embodiment of sensing circuitry 208, although it is understood that sensing circuitry 208 could be embodied in other manners without departing from the scope hereof. Sensing circuitry 700 includes an amplifier 702, a first switch 704, a second switch 706, and a current sense resistor 708. Current sense resistor 708 is electrically coupled between filter 204 and analog output node 218, and a voltage $V_r$ across current sense resistor 708 is therefore proportional to magnitude of current $I_{ao}$. Amplifier 702 is configured to generate analog feedback signal $A_{fb}$ in proportion to magnitude of voltage across its inputs. First switch 704 is configured to (a) electrically couple an non-inverting input of amplifier 702 to a side of current sense resistor 708 connected to filter 204 when control signal $c$ is de-asserted and (b) electrically couple the non-inverting input of amplifier 702 to a side of current sense resistor 708 connected to analog output node 218 when control signal $c$ is asserted. Second switch 706 is configured to (a) electrically couple an inverting input of amplifier 702 to the side of current sense resistor 708 connected to analog output node 218 when control signal $c$ is de-asserted and (b) electrically couple an inverting input of amplifier 702 to reference node 220 when control signal $c$ is asserted. As such, analog feedback signal $A_{fb}$ represents current $I_{ao}$ when control signal $c$ is de-asserted, and analog feedback signal $A_{fb}$ represents voltage $V_{ao}$ when control signal $c$ is asserted. In some alternate embodiments, first switch 704 and second switch 706 are controlled by different respective control signals instead of by a common control signal $c$.

Referring again to FIG. 2, ADC 210 is configured to convert analog feedback signal $A_{fb}$ to digital feedback signal $D_{fb}$, which is provided to circuitry 206. Circuitry 206 is configured to configure Class-D amplifier 202 for an impedance of the load 212 by generating digital internal signal $D_{int}$ based on the digital feedback signal $D_{fb}$, as well as based on one or more input signals 226, such as to regulate magnitude of current $I_{ao}$ or voltage $V_{ao}$ while amplifying digital internal signal $D_{int}$. Stated differently, not only does electrical environment 200 amplify internal digital signal $D_{int}$, but electrical environment 200 also amplifies digital signal $D_{int}$ in a manner which achieves a desired value of current $I_{ao}$ or voltage $V_{ao}$, irrespective of impedance of load 212. For example, certain embodiments of circuitry 206 are configured to generate an error signal $ERR$ according to EQN. 2 below, where K is a proportionality constant, $D_{ref}$ is a digital reference value, such as a digital reference value representing a desired magnitude of current $I_{ao}$ or a desired magnitude of voltage $V_{ao}$. For example, in certain embodiments, digital reference value $D_{ref}$ is equal to, or is a scaled version of, a desired magnitude of current $I_{ao}$ or a desired magnitude of voltage $V_{ao}$. Particular embodiments of circuitry 206 are configured to generate digital internal signal $D_{int}$ based on one or more of input signals 226 in a manner that minimizes error signal $ERR$, thereby achieving a required value of current $I_{ao}$ or voltage $V_{ao}$ over a range of impedance values of load 212. Accordingly, in these embodiments, electrical environment 200 implements a closed-loop control system to regulate one or more of current $I_{ao}$ and voltage $V_{ao}$, such as in response to changing magnitude of impedance of load 212, to configure Class-D amplifier 202 for impedance of load 212.

$$ERR = K \cdot \left( D_{fb} - D_{ref} \right) \quad \text{EQN. 2}$$

For example, assume that (a) circuitry 206 determines from an input signals 226 that magnitude of current $I_{ao}$ should be 20 mA and (b) impedance of load 212 may vary between zero and 1,000 ohms. In this example, $D_{fb}$ would represent magnitude of current $I_{ao}$ and digital reference value $D_{ref}$ would represent 20 mA. Circuitry 206 would generated digital internal signal $D_{int}$ as required to achieve a magnitude of current $I_{ao}$ of 20 mA irrespective of the impedance of load 212. For instance, if load 212 had an impedance of 50 ohms, circuitry 206 would generate digital internal signal $D_{int}$ as required so that an average value of voltage $V_{od}$ is 1 volt, which would result in magnitude of current $I_{ao}$ being 20 mA with the 50 ohm load, thereby configuring Class-D amplifier for the 50 ohm load. As another example, if load 212 had an impedance of 750 ohms, circuitry 206 would generated digital internal signal $D_{int}$ as required so that an average value of voltage $V_{od}$ is 15 volts, which would result in magnitude of current $I_{ao}$ being 20 mA with the 750 ohm load, thereby configuring Class-D amplifier for the 750 ohm load.

As another example, assume that (a) circuitry 206 determines from an input signals 226 that magnitude of voltage $V_{ao}$ should be 5 volts and (b) impedance of load 212 may vary between 200 and 1,000 ohms. In this example, $D_{fb}$ would represent magnitude of voltage $V_{ao}$ and digital reference value $D_{ref}$ would represent 5 volts. Circuitry 206 would generate digital internal signal $D_{int}$ as required to achieve a magnitude of voltage $V_{ao}$ of 5 volts irrespective of the impedance of load 212. For instance, if load 212 had an impedance of 200 ohms, circuitry 206 would generate digital internal signal $D_{int}$ as required so that an average value of current $I_{od}$ is 25 mA, which would result in magnitude of voltage $V_{ao}$ being 5 volts with the 200 ohm load, thereby configuring Class-D amplifier for the 200 ohm load. As another example, if load 212 had an impedance of 1,000 ohms, circuitry 206 would generate digital internal signal $D_{int}$ as required so that an average value of current $I_{od}$ is 5 mA, which would result in magnitude of voltage $V_{ao}$ would being 5 volts with the 1,000 ohm load, thereby configuring Class-D amplifier for the 1,000 ohm load.

It should be appreciated that a Class-D amplifier, such as Class-D amplifier 202 of electrical environment 200, does not include transistors continuously operating in their saturation regions. Consequently, Class-D amplifier 202 does not dissipate a large amount of power, even when load 212 has a low impedance. Additionally, Class-D amplifier 202 is capable of powering load 212 when load 212 has a high impedance. Such ability of Class-D amplifier 202 to drive a load having a wide possible impedance range may be particularly advantageous in embodiments where impedance of load 212 is not known before deployment of Class-D amplifier 202 in electrical environment 200.

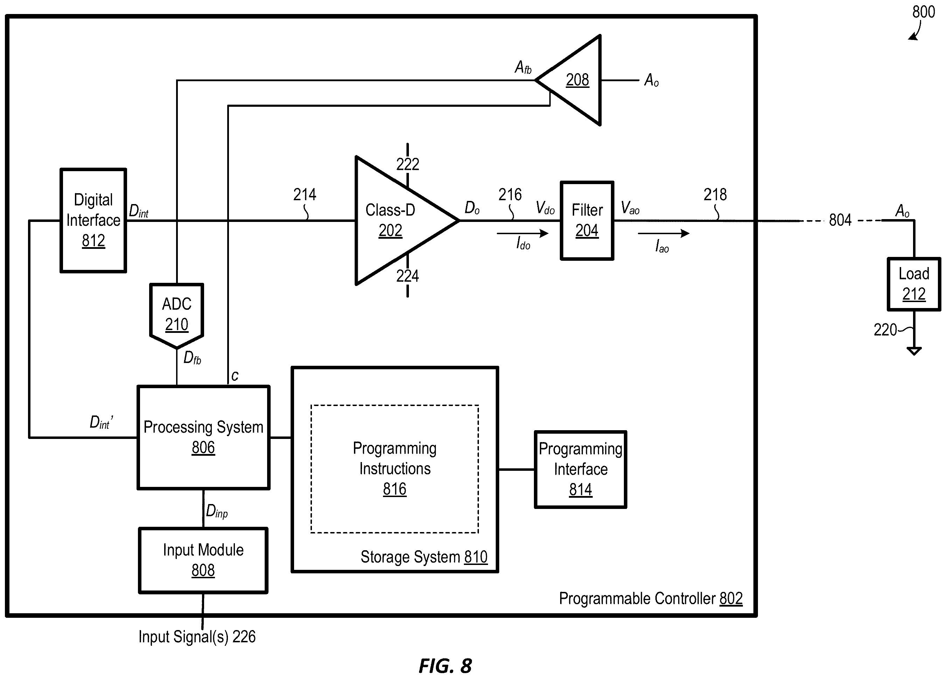

One possible application of the new systems and methods for providing an analog output signal using a Class-D amplifier is a programmable controller application, such as a PLC application, a PAC application, or a DCS application. For example, FIG. 8 is a block diagram of an electrical environment 800 including a programmable controller 802, an electrical cable 804, and an instance of load 212. Electrical cable 804 electrically couples filter 204 to load 212, and electrical cable 804 is therefore part of analog output node 218. In certain embodiments, electrical cable 804 is relatively long, e.g., tens of meters in length, hundreds of meters in length, or even longer.

Programmable controller 802 includes an instance of Class-D amplifier 202, filter 204, sensing circuitry 208, and ADC 210. Additionally, circuitry 206 of FIG. 2 is collectively embodied by a processing system 806, an input module 808, a storage system 810, a digital interface 812, and an optional programming interface 814, in programmable controller 802. Two or more of the aforesaid elements of programmable controller 802 could be partially or fully combined without departing from scope hereof. Input module 808 is configured to receive one or more input signals 226 from outside of programmable controller 802 and provide the one or more input signals to processing system 806 as digital input signals $D_{inp}$. Input signals 226 may be analog input signals, digital signals, or a combination of analog and digital input signals. In embodiments where input signals 226 include analog input signals, input module 808 includes at least one ADC (not shown). In some embodiments, input signals 226 are generated by one or more of switch, a sensor, and an encoder.

Storage system 810 stores programming instructions 816, such as in the form of software and/or firmware, for execution by processing system 806. Storage system 810 is optionally configured to store additional information, such as digital input signals $D_{inp}$ and/or working information for use by processing system 806. Processing system 806 is configured to generate digital internal signal $D_{int}'$ at least partially according to programming instructions 816 and digital feedback signal $D_{fb}$, and optionally further according to digital input signals $D_{inp}$. Additionally, processing system 806 is configured to generate control signal c at least partially according to programming instructions 816 and optionally further according to digital input signals $D_{inp}$. Digital interface 812 is configured to receive digital internal signal $D_{int}'$ from processing system 806, and digital interface 812 is configured to provide digital internal signal $D_{int}'$ to Class-D amplifier 202 as digital internal signal $D_{int}$. In some embodiments, digital internal signal $D_{int}$ is identical to digital internal signal $D_{int}'$, while in other embodiments, digital internal signal $D_{int}$ is derived from, but is not identical to, digital internal signal $D_{int}'$. In particular embodiments, digital internal signal $D_{int}'$ is a serial communication signal. In some alternate embodiments, digital interface 812 is omitted and processing system 806 is configured to directly generate digital internal signal $D_{int}$. Class-D amplifier 202 and filter 204 are collectively configured to generate analog output signal $A_o$ in response to digital internal signal $D_{int}$ as discussed above with respect to FIG. 2. Additionally, sensing circuitry 208 and ADC 210 are collectively configured to generate digital feedback signal $D_{fb}$ as discussed above with respect to FIG. 2.

Programmable controller 802 may be, for example, a programmable logic controller, a programmable automation controller, or a programmable controller of a digital control system, such as based on the configuration of programming instructions 816. For example, programming instructions 816 may include (a) instructions that cause programmable controller 802 to operate as a programmable logic controller, (b) instructions that cause programmable controller 802 to operate as a programmable automation controller, or (c) instructions that cause programmable controller 802 to operate as a programmable controller of a digital control system.

Optional programming interface 814 enables creation and/or modification of programming instructions 816. Certain embodiments of programming interface 814 include one or more user input devices and/or user output devices, such as a keyboard, a switch, a mouse, a touch pad, a screen, a monitor, a printer, etc. Additionally, some embodiments of programming interface 814 include one or more interfaces to an external system, such as an electrical interface (e.g., a Universal Serial Bus (USB) electrical interface and/or or an Ethernet electrical interface), a wireless interface (e.g., a Bluetooth wireless interface, a Wi-Fi wireless interface, a cellular wireless interface, and/or a satellite wireless interface), an optical interface (e.g., an optical cable interface and/or a free space optical interface), and/or a logical interface (e.g., an application programming interface (API)).

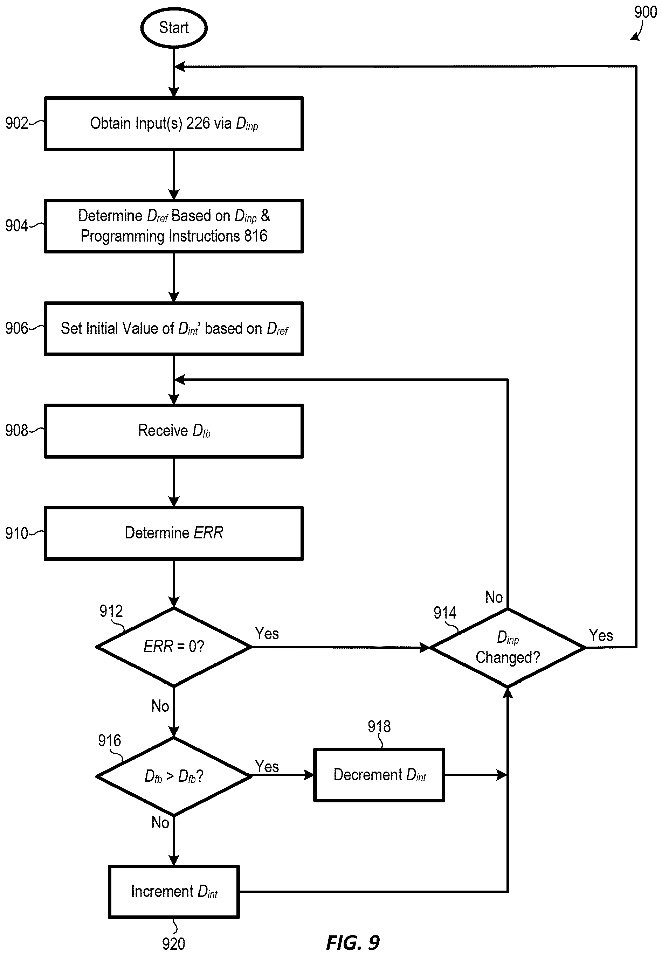

FIG. 9 is a flow chart of a method 900 for generating an analog output signal using a Class-D amplifier, which is one example of operation of programmable controller 802. It is understood, though, that programmable controller 802 is not limited to operating according to method 900.

In a block 902 of method 900, processing system 806 obtains one or more input signals 226 as digital input signals $D_{inp}$. In a block 904 of method 900, processing system 806 determines digital reference value $D_{ref}$, where digital reference value $D_{ref}$ represents a desired value of analog output signal $A_o$, based on digital input signals $D_{inp}$ and programming instructions 816. In one example of block 904, processing system 806 executes an algorithm defined by programming instructions 816, where the algorithm generates digital reference value $D_{ref}$ as a function of digital input signals $D_{inp}$. In a block 906, processing system 806 executes programming instructions 816 to set an initial value of digital internal signal $D_{int}$' as a function of digital reference value $D_{ref}$ In one example of block 906, processing system 806 executes programming instructions 816 to set the initial value of digital internal signal $D_{int}$' to digital reference value $D_{ref}$

In a block 908 of method 900, processing system 806 receives digital feedback signal $D_{fb}$ from ADC 210. In a block 910 of method 900, processing system 806 execute programming instructions 816 to determine an error signal *ERR,* such as by executing EQN. 2 above or by executing a variation of EQN. 2 above, where error signal ERR represents a difference between digital feedback signal $D_{fb}$ and digital reference value $D_{ref}$ In a decision block 912, processing system 806 executes programming instructions 816 to determine if error signal *ERR* is equal to zero, or if error signal *ERR* is within a predetermine tolerance of zero. If the result of decision block 912 is yes, method 900 to proceeds to decision block 914 where processing system 806 executes programming instructions 816 to determine if digital input signals $D_{inp}$ have changed. If the result of decision block 914 is yes, method 900 returns to block 902 to obtain one or more new digital input signals $D_{inp}$, and if the result of decision block 914 is no, method 900 returns to block 908 to obtain an updated digital feedback signal $D_{fb}$.

Referring again to decision block 912, if the result of decision block 912 is no, method 900 proceeds from decision block 912 to decision block 916, where processing system 806 executes programming instructions 816 to determine if digital feedback signal $D_{fb}$ is greater than digital reference value $D_{ref}$ If the result of decision block 916 is yes, magnitude of analog output signal $A_o$ is too large, and method 900 therefore proceeds to a block 918 where processing system 806 executes programming instructions 816 to decrement digital internal signal $D_{int}$' and thereby decrease magnitude of analog output signal $A_o$. On the other hand, if the result of decision block 916 is no, magnitude of analog output signal $A_o$ is too small, and method 900 therefore proceeds to a block 920 where processing system 806 executes programming instructions 816 to increment digital internal signal $D_{int}$' and thereby increase magnitude of analog output signal $A_o$. Method 900 proceeds from either of block 918 or block 920 to decision block 914 (discussed above). While FIG. 9 does not illustrate method 900 having a "Stop" block, it is understood that processing system 806 could interrupt method 900 at any time, such as in response to a signal to inhibit generation analog output signal $A_o$.

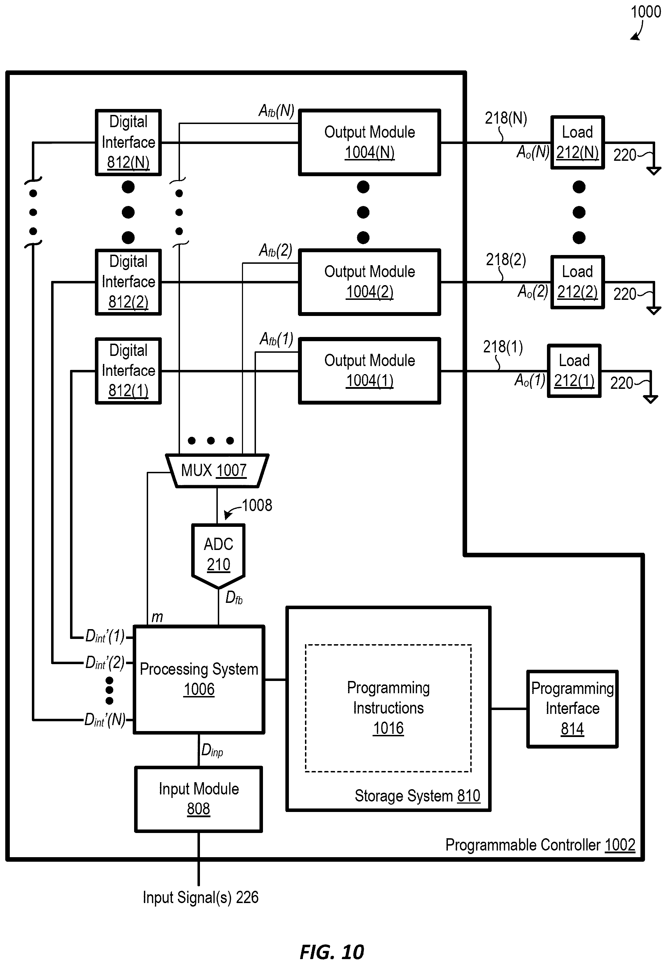

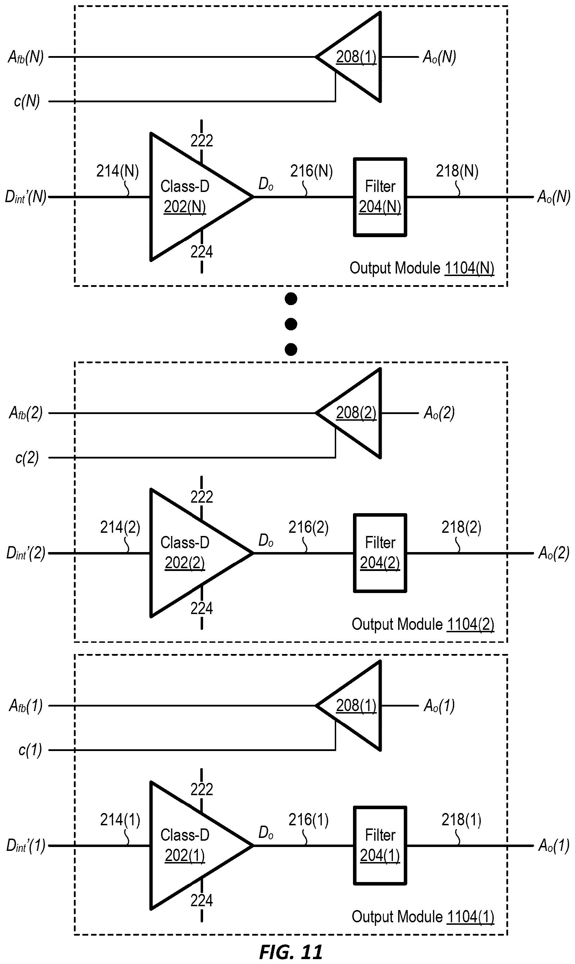

Referring again to FIG. 8, programmable controller 802 could be modified to support additional channels, i.e., to be capable of generating multiple instances of analog output signal $A_o$ for driving a plurality of different respective loads. For example, FIG. 10 is a block diagram of an electrical environment 1000 including a programmable controller 1002 and N loads 212, where N is an integer greater than one. In this document, specific instances of an item may be referred to by use of a numeral in parentheses (e.g. load 212(1)) while numerals without parentheses refer to any such item (e.g. loads 212). Programmable controller 1002 is an alternate embodiment of programmable controller 802 (FIG. 8) further including N output modules 1004 and a multiplexor 1007. Each output module 1004 includes at least a respective instance of Class-D amplifier 202, filter 204, and sensing circuitry 208. Details of output module 1004 are not shown in FIG. 10, but FIG. 11 illustrate N output modules 1104, where output modules 1104(1)-1104(N) are embodiments of output modules 1004(1)-1004(N), respectively.

Programmable controller 1002 additionally includes a processing system 1006 and programming instructions 1016 in place of processing system 806 and programming instructions 816, respectively. Processing system 1006 in similar to processing system 806 of FIG. 8 except that processing system 1006 is configured to generate N digital internal signals $D_{int}$', i.e., a respective digital internal signal $D_{int}$' for each output module 1004, instead of a single digital internal signal $D_{int}$'. For example, in certain embodiments, processing system 1006 is configured to generate each digital internal signal $D_{int}$' at least partially according to programming instructions 1016 and optionally further according to digital input signals $D_{inp}$. In certain embodiments, each digital internal signal $D_{int}$' may have a different respective value at any given time, while in certain other embodiments, two or more digital internal signal $D_{int}$' have a common value at any given time. Programming instructions 1016 are similar to programming instructions 816 except that programming instructions 1016 are capable of supporting generation of N digital internal signals $D_{int}$', instead of solely a single digital internal signal. Control signals c between processing system 1006 and output modules 1004 are not shown in FIG. 10 for illustrative clarity, but it is understood that in certain embodiments, processing system 1006 provides a respective control c to each output module 1004, such as to control whether the respective analog feedback signal $A_{fb}$ generated by the output module represents a current $I_{ao}$ or a voltage $V_{ao}$.

Multiplexor 1007 is configured to multiplex analog feedback signals $A_{fb}$ before an input 1008 to ADC 210. For example, in some embodiments, multiplexor 1007 is configure to selectively communicatively couple one analog feedback signal $A_{fb}$ instance to ADC 210 at a given time in response to control signal *m* from processing system 1006, such as to enable ADC 210 to be shared by all N output modules 1004. For example, in particular embodiments, processing system 1006 generates control signal *m* to cause multiplexor 1007 to sequentially communicatively couple feedback signals $A_{fb}$ to ADC 210, so that each feedback signal $A_{fb}$ is periodically communicatively coupled to ADC 210 at a different respective time than each other feedback signal $A_{fb}$. Accordingly, in particular embodiments, processing system 1006 sequentially receives a respective digital feedback signal $D_{fb}$ for each output module 1004, and processing system 1006 generates each digital internal signal $D_{int}'$ at least partially based on a corresponding digital feedback signal $D_{fb}$.

It should be noted that not only do all channels of programmable controller 1002 share ADC 210, but some embodiments of programmable controller 1002 only require N inductors, i.e., a respective inductor for the filter 204 of each output module 1004, excluding any required power supply inductors. As such, the configuration of programmable controller 1002 promotes small size, low complexity, and low cost, of the programmable controller.

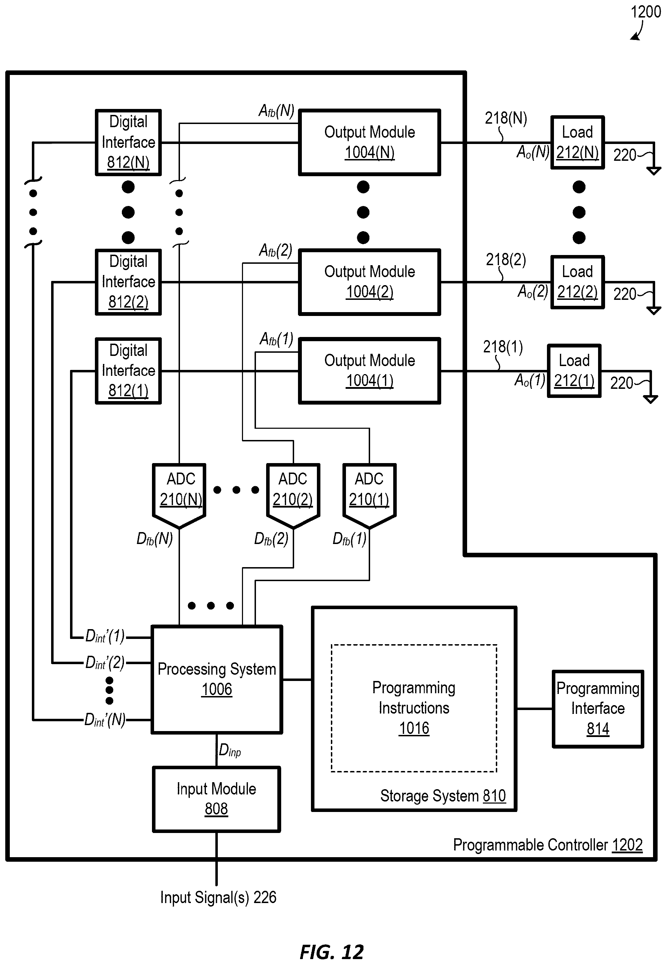

Programmable controller 1002 could be modified to omit multiplexor 1007 and to include a respective ADC 210 for each channel. For example, FIG. 12 is a block diagram of an electrical environment 1200, which is an alternate embodiment of electrical environment 1000 (FIG. 10) including programmable controller 1202 in place of programmable controller 1002. Programmable controller 1202 differs from programmable controller 1002 in that (a) multiplexor 1007 is omitted from programmable controller 1202 and (b) programmable controller 1202 includes a respective ADC 210 for each channel. Each ADC 210 is configured to convert a respective analog feedback signal $A_{fb}$ to a respective digital feedback signal $D_{fb}$, and each digital feedback signal $D_{fb}$ is communicatively coupled to processing system 1006. As such, processing system 1006 may simultaneously receive a plurality of digital feedback signals $D_{fb}$, and certain embodiments of processing system 1006 are accordingly configured to simultaneously generate a plurality of digital internal signals $D_{int}'$.

## Combinations of Features

Features described above may be combined in various ways without departing from the scope hereof. The following examples illustrate some possible combinations.

(A1) A method for providing an analog output signal includes (1) amplifying a digital first internal signal using a first Class-D amplifier to generate a digital first output signal, (2) filtering the digital first output signal to generate an analog first output signal, (3) providing the analog first output signal to a first load, (4) sensing the analog first output signal to generate an analog first feedback signal, (5) converting the analog first feedback signal to a digital first feedback signal, and (6) configuring the first Class-D amplifier for an impedance of the first load by generating the digital first internal signal at least partially based on the digital first feedback signal.

(A2) In the method denoted as (A1), sensing the analog first output signal may include one of sensing a voltage across the first load and sensing a magnitude of current flowing through the first load.

(A3) In either one of the methods denoted as (A1) and (A2), an impedance of the first load may vary independently of a state of the analog first output signal.

(A4) In any one of the methods denoted as (A1) through (A3), an impedance of the first load may range from zero to 1,000 ohms.

(A5) In any one of the methods denoted as (A1) through (A4), the first load may include an industrial device.

(A6) In any one of the methods denoted as (A1) through (A5), the analog first output signal may be a current signal.

(A7) In any one of the methods denoted as (A1) through (A5), the analog first output signal may be a voltage signal.

(A8) In any one of the methods denoted as (A1) through (A7), generating the digital first internal signal at least partially based on the digital first feedback signal may include generating the digital first internal signal to achieve an average value of the digital first output signal that is a function of an impedance of the first load.

(A9) In any one of the methods denoted as (A1) through (A8), generating the digital first internal signal at least partially based on the digital first feedback signal may include generating the digital first internal signal at least partially based on a difference between the digital first feedback signal and a first reference value.

(A10) Any one of the methods denoted as (A1) through (A9) may further include (1) using a first analog-to-digital converter (ADC) to convert the analog first feedback signal to the digital first feedback signal and (2) multiplexing the analog first feedback signal with an analog second feedback signal before an input to the first ADC.

(A11) In the method denoted as (A10), multiplexing the analog first feedback signal with the analog second feedback signal may include communicatively coupling the analog first feedback signal and the analog second feedback signal to the input of the first ADC at different respective times.

(A12) Either one of the methods denoted as (A10) and (A11) may further include (1) amplifying a digital second internal signal using a second Class-D amplifier to generate a digital second output signal, (2) filtering the digital second output signal to generate an analog second output signal, (3) providing the analog second output signal to a second load, and (4) sensing the analog second output signal to generate the analog second feedback signal.

(A13) The method denoted as (A12) may further include using the first ADC to convert the analog second feedback signal to a digital second feedback signal.

(A14) The method denoted as (A13) may further include configuring the second Class-D amplifier for an impedance of the second load by generating the digital second internal signal at least partially based on the digital second feedback signal.

(B1) A programmable controller includes (1) a processing system configured to generate a digital first internal signal at least partially according to (a) programming instructions provided to the processing system and (b) a digital first feedback signal, (2) a first Class-D amplifier configured to amplify the digital first internal signal to generate a digital first output signal, (3) a first filter configured to filter the digital first output signal to generate an analog first output signal, (4) first sensing circuitry configured to sense the analog first output signal to generate an analog first feedback signal, and (5) a first analog-to-digital converter (ADC) configured to convert the analog first feedback signal to the digital first feedback signal.

(B2) In the programmable controller denoted as (B1), the processing system may be configured to generate the digital first internal signal at least partially according to the digital first feedback signal to configure the first Class-D amplifier for an impedance of a first load receiving the analog first output signal

(B3) In either one of the programmable controllers denoted as (B1) and (B2), the first filter may include an inductive-capacitive filter.

(B4) In any one of the programmable controllers denoted as (B1) through (B3), the programmable controller may be selected from the group consisting of a programmable logic controller (PLC), a programmable automation controller (PAC), and a controller of a digital control system (DCS).

(B5) Any one of the programmable controllers denoted as (B1) through (B4) may further include a programming interface enabling modification of the programming instructions provided to the processing system.

(B6) In any one of the programmable controllers denoted as (B1) through (B5), the processing system may be further configured to generate the digital first internal signal at least partially according to one or more input signals received by the programmable controller.

(B7) Any one of the programmable controllers denoted as (B1) through (B6) may further include a multiplexor configured to multiplex the analog first feedback signal with an analog second feedback signal before an input to the first ADC.

(B8) In the programmable controller denoted as (B7), (1) the processing system may be further configured to generate a digital second internal signal at least partially according to (a) programming instructions provided to the processing system and (b) a digital second feedback signal, and (2) the programmable controller may further include (i) a second Class-D amplifier configured to amplify the digital second internal signal to generate a digital second output signal, (ii) a second filter configured to filter the digital second output signal to generate an analog second output signal, and (iii) second sensing circuitry configured to sense the analog second output signal to generate the analog second feedback signal.

(B9) In the programmable controller denoted as (B8), the first ADC may be further configured to convert the analog second feedback signal to the digital second feedback signal.

(C1) An electrical environment includes a programmable controller and a first load. The programmable controller includes (i) a processing system configured to generate a digital first internal signal at least partially according to (a) programming instructions provided to the processing system and (b) a digital first feedback signal, (ii) a first Class-D amplifier configured to amplify the digital first internal signal to generate a digital first output signal, (iii) a first filter configured to filter the digital first output signal to generate an analog first output signal, (iv) first sensing circuitry configured to sense the analog first output signal to generate an analog first feedback signal, and (v) a first analog-to-digital converter (ADC) configured to convert the analog first feedback signal to the digital first feedback signal. The first load is powered by the analog first output signal.

(C2) The electrical environment denoted as (C1) may further include an electrical cable electrically coupling the first load to the programmable controller.

(C3) In either one of the electrical environments denoted as (C1) and (C2), an impedance of the first load may range from zero to 1,000 ohms.

(C4) In any one of the electrical environments denoted as (C1) through (C3), the programmable controller may be selected from the group consisting of a programmable logic controller (PLC), a programmable automation controller (PAC), and a controller of a digital control system (DCS).

(C5) In any one of the electrical environments denoted as (C1) through (C4), the processing system may be configured to generate the digital first internal signal at least partially according to the digital first feedback signal to configure the first Class-D amplifier for an impedance of the first load.

Changes may be made in the above methods, devices, and systems without departing from the scope hereof. It should thus be noted that the matter contained in the above description and shown in the accompanying drawings should be interpreted as illustrative and not in a limiting sense. The following claims are intended to cover generic and specific features described herein, as well as all statements of the scope of the present method and system, which as a matter of language, might be said to fall therebetween.

**Claims**

1. A method for providing an analog output signal, the method comprising:

   amplifying a digital first internal signal using a first Class-D amplifier to generate a digital first output signal;
   filtering the digital first output signal to generate an analog first output signal;
   providing the analog first output signal to a first load;
   sensing the analog first output signal to generate an analog first feedback signal;
   converting the analog first feedback signal to a digital first feedback signal; and
   configuring the first Class-D amplifier for an impedance of the first load by generating the digital first internal signal at least partially based on the digital first feedback signal.

2. The method of claim 1, wherein sensing the analog first output signal comprises one of sensing a voltage across the first load and sensing a magnitude of current flowing through the first load.

3. The method of any preceding claim, wherein an impedance of the first load may vary independently of a state of the analog first output signal.

4. The method of any preceding claim, wherein the analog first output signal is one of a current signal and a voltage signal.

5. The method of any preceding claim, wherein generating the digital first internal signal at least partially based on the digital first feedback signal comprises generating the digital first internal signal to achieve an average value of the digital first output signal that is a function of an impedance of the first load.

6. The method of any preceding claim, wherein generating the digital first internal signal at least partially based on the digital first feedback signal comprises generating the digital first internal signal at least partially based on a difference between the digital first feedback signal and a first reference value.

7. The method of any preceding claim, further comprising:

   using a first analog-to-digital converter (ADC) to convert the analog first feedback signal to the digital first feedback signal; and
   multiplexing the analog first feedback signal with an analog second feedback signal before an input to the first ADC.

8. The method of claim 7, wherein multiplexing the analog first feedback signal with the analog second feedback signal comprises communicatively coupling the analog first feedback signal and the analog second feedback signal to the input of the first ADC at different respective times.

9. The method of claim 7 or claim 8, further comprising:

   amplifying a digital second internal signal using a second Class-D amplifier to generate a digital second output signal;
   filtering the digital second output signal to generate an analog second output signal;
   providing the analog second output signal to a second load; and
   sensing the analog second output signal to generate the analog second feedback signal.

10. The method of claim 9, further comprising using the first ADC to convert the analog second feedback signal to a digital second feedback signal,
    and optionally further comprising configuring the second Class-D amplifier for an impedance of the second load by generating the digital second internal signal at least partially based on the digital second feedback signal.

11. A programmable controller, comprising:

    a processing system configured to generate a digital first internal signal at least partially according to (a) programming instructions provided to the processing system and (b) a digital first feedback signal;
    a first Class-D amplifier configured to amplify the digital first internal signal to generate a digital first output signal;

a first filter configured to filter the digital first output signal to generate an analog first output signal;

first sensing circuitry configured to sense the analog first output signal to generate an analog first feedback signal; and

a first analog-to-digital converter (ADC) configured to convert the analog first feedback signal to the digital first feedback signal.

12. The programmable controller of claim 11, wherein at least one of the following applies:

(A) the processing system is configured to generate the digital first internal signal at least partially according to the digital first feedback signal to configure the first Class-D amplifier for an impedance of a first load receiving the analog first output signal;

(B) the first filter comprises an inductive-capacitive filter;

(C) the processing system is further configured to generate the digital first internal signal at least partially according to one or more input signals received by the programmable controller.

13. The programmable controller of claim 11 or claim 12, further comprising a multiplexor configured to multiplex the analog first feedback signal with an analog second feedback signal before an input to the first ADC.

14. The programmable controller of claim 13, wherein:

the processing system is further configured to generate a digital second internal signal at least partially according to (a) programming instructions provided to the processing system and (b) a digital second feedback signal; and

the programmable controller further comprises:

a second Class-D amplifier configured to amplify the digital second internal signal to generate a digital second output signal,

a second filter configured to filter the digital second output signal to generate an analog second output signal, and

second sensing circuitry configured to sense the analog second output signal to generate the analog second feedback signal,

and optionally wherein the first ADC is further configured to convert the analog second feedback signal to the digital second feedback signal.

15. An electrical environment, comprising:

a programmable controller, including:

a processing system configured to generate a digital first internal signal at least partially according to (a) programming instructions provided to the processing system and (b) a digital first feedback signal,

a first Class-D amplifier configured to amplify the digital first internal signal to generate a digital first output signal,

a first filter configured to filter the digital first output signal to generate an analog first output signal,

first sensing circuitry configured to sense the analog first output signal to generate an analog first feedback signal, and

a first analog-to-digital converter (ADC) configured to convert the analog first feedback signal to the digital first feedback signal; and

a first load powered by the analog first output signal,

and optionally further comprising an electrical cable electrically coupling the first load to the programmable controller.

$V_s$

Programmable
Controller
102

$I_o$

$V_o$
+
−

Load
104

**FIG. 1**

100

200

$A_{fb}$

208

$A_o$

ADC
210

$D_{fb}$

$c$

Logic &
Interface
Circuitry
206

$D_{int}$

214

222

Class-D
202

$D_o$

216

$V_{do}$

$I_{do}$

Filter
204

$A_o$

218

$I_{ao}$

224

$V_{ao}$
+
−

Load
212

220

Input(s) 226

**FIG. 2**

300

$V_{do}$

$V_{222}$

$V_{do\_avg}$

0 — Time

$V_{224}$

**FIG. 3**

400

$I_{do}$

402

$I_{do\_avg}$

404

Time

**FIG. 4**

500

222

504

Φ1

To Logic &
Interface
Circuitry 206

214

$D_{int}$ Modulator
502

216

$D_o$

To Filter 204

506

Φ2

224

**FIG. 5**

**FIG. 8**

EP 4 513 755 A1

**FIG. 9**

Start

902 — Obtain Input(s) 226 via $D_{inp}$

904 — Determine $D_{ref}$ Based on $D_{inp}$ & Programming Instructions 816

906 — Set Initial Value of $D_{int}'$ based on $D_{ref}$

908 — Receive $D_{fb}$

910 — Determine $ERR$

912 — $ERR = 0$?

914 — $D_{inp}$ Changed?

916 — $D_{fb} > D_{fb}$?

918 — Decrement $D_{int}$

920 — Increment $D_{int}$

900

1000

| | | | $A_{fb}(N)$ | | | | | |
|---|---|---|---|---|---|---|---|---|

Digital Interface 812(N)

Output Module 1004(N)

218(N)

Load 212(N)

$A_o(N)$

220

Digital Interface 812(2)

$A_{fb}(2)$

Output Module 1004(2)

218(2)

Load 212(2)

$A_o(2)$

220

Digital Interface 812(1)

$A_{fb}(1)$

Output Module 1004(1)

218(1)

Load 212(1)

$A_o(1)$

220

MUX 1007

1008

ADC 210

$D_{fb}$

$D_{int}'(1)$
$D_{int}'(2)$
$D_{int}'(N)$

$m$

Processing System 1006

Programming Instructions 1016

Storage System 810

Programming Interface 814

$D_{inp}$

Input Module 808

Programmable Controller 1002

Input Signal(s) 226

**FIG. 10**

*FIG. 11*

1200

| | |
|---|---|
| Digital Interface 812(N) | |

$A_{fb}(N)$

Output Module 1004(N)

218(N)

Load 212(N)

220

$A_o(N)$

Digital Interface 812(2)

$A_{fb}(2)$

Output Module 1004(2)

218(2)

Load 212(2)

220

$A_o(2)$

Digital Interface 812(1)

$A_{fb}(1)$

Output Module 1004(1)

218(1)

Load 212(1)

220

$A_o(1)$

ADC 210(N)

ADC 210(2)

ADC 210(1)

$D_{fb}(N)$

$D_{fb}(2)$

$D_{fb}(1)$

$D_{int}'(1)$

$D_{int}'(2)$

$D_{int}'(N)$

Processing System 1006

Programming Instructions 1016

Programming Interface 814

Storage System 810

$D_{inp}$

Input Module 808

Programmable Controller 1202

Input Signal(s) 226

*FIG. 12*

# EP 4 513 755 A1

Europäisches
Patentamt

European
Patent Office

Office européen
des brevets

# EUROPEAN SEARCH REPORT

**Application Number**

EP 24 19 4244

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/114399 A1 (HIGUCHI KOUJI [JP] ET AL) 6 May 2010 (2010-05-06) | 1-6,11, 12,15 | INV. H03F3/183 |
| A | * paragraphs [0051], [0041], [0065], [0037], [0048]; figures 1,2,6 * | 7-10,13, 14 | H03F3/217 H03G3/30 H02M1/00 |
| | ----- | | |
| X | US 2008/252277 A1 (SASE TAKASHI [JP] ET AL) 16 October 2008 (2008-10-16) | 1,11,15 | |
| A | * abstract; figure 1 * | 2-10, 12-14 | |
| | ----- | | |
| X | OLIVIER TRESCASES ET AL: "Digitally Controlled Current-Mode DC-DC Converter IC", IEEE TRANSACTIONS ON CIRCUITS AND SYSTEMS I: REGULAR PAPERS, IEEE, US, vol. 58, no. 1, 2 January 2011 (2011-01-02), pages 219-231, XP011340992, ISSN: 1549-8328, DOI: 10.1109/TCSI.2010.2071490 | 1,11,15 | |
| A | * abstract; figure 2 * | 2-10, 12-14 | **TECHNICAL FIELDS SEARCHED (IPC)** |
| | ----- | | H03F |
| A | US 2009/079401 A1 (MOK KEN TSZ KIN [US] ET AL) 26 March 2009 (2009-03-26) * abstract; figure 2 * | 1-15 | H03G H02M |
| | ----- | | |

The present search report has been drawn up for all claims

| Place of search | Date of completion of the search | Examiner |
|---|---|---|
| The Hague | 7 January 2025 | Zakharian, Andre |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

....................................................................

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 19 4244

This annex lists the patent family members relating to the patent documents cited in the above-mentioned European search report.
The members are as contained in the European Patent Office EDP file on
The European Patent Office is in no way liable for these particulars which are merely given for the purpose of information.

07-01-2025

| Patent document cited in search report | | Publication date | Patent family member(s) | | Publication date |
|---|---|---|---|---|---|
| US 2010114399 | A1 | 06-05-2010 | CN | 101553976 A | 07-10-2009 |
| | | | GB | 2456977 A | 05-08-2009 |
| | | | JP | 4877661 B2 | 15-02-2012 |
| | | | JP | WO2008072618 A1 | 02-04-2010 |
| | | | US | 2010114399 A1 | 06-05-2010 |
| | | | WO | 2008072618 A1 | 19-06-2008 |
| US 2008252277 | A1 | 16-10-2008 | JP | 5186148 B2 | 17-04-2013 |
| | | | JP | 2008113542 A | 15-05-2008 |
| | | | US | RE43946 E | 29-01-2013 |
| | | | US | 2008252277 A1 | 16-10-2008 |
| US 2009079401 | A1 | 26-03-2009 | CN | 101809853 A | 18-08-2010 |
| | | | EP | 2193598 A1 | 09-06-2010 |
| | | | JP | 5313252 B2 | 09-10-2013 |
| | | | JP | 2010541530 A | 24-12-2010 |
| | | | KR | 20100051881 A | 18-05-2010 |
| | | | TW | 200929815 A | 01-07-2009 |
| | | | US | 2009079401 A1 | 26-03-2009 |
| | | | WO | 2009042704 A1 | 02-04-2009 |

EPO FORM P0459

For more details about this annex : see Official Journal of the European Patent Office, No. 12/82